(19) Europäisches Patentamt
European Patent Office
Office européen des brevets

(11) EP 2 014 702 B1

(12) EUROPEAN PATENT SPECIFICATION

(45) Date of publication and mention of the grant of the patent:
**06.01.2010 Bulletin 2010/01**

(51) Int Cl.:
***C08G 77/22*** *(2006.01)* ***H01L 23/29*** *(2006.01)*
***H01L 33/00*** *(2010.01)*

(21) Application number: **08012126.2**

(22) Date of filing: **04.07.2008**

# (54) LED device comprising a polyborosiloxane

LED-Vorrichtung enthaltend Polyborsiloxan

Dispositif DEL contenant du polyborosiloxane

(84) Designated Contracting States:
**DE NL**

(30) Priority: **11.07.2007 JP 2007182486**

(43) Date of publication of application:
**14.01.2009 Bulletin 2009/03**

(73) Proprietor: **Nitto Denko Corporation**
**Ibaraki-shi, Osaka 567-8680 (JP)**

(72) Inventors:
- **Katayama, Hiroyuki**
**Ibaraki-shi**
**Osaka (JP)**
- **Akazawa, Kouji**
**Ibaraki-shi**
**Osaka (JP)**

(74) Representative: **Grünecker, Kinkeldey, Stockmair & Schwanhäusser**
**Anwaltssozietät**
**Leopoldstrasse 4**
**80802 München (DE)**

(56) References cited:

| | |
|---|---|
| **EP-A- 1 684 363** | **JP-A- 8 268 735** |
| **JP-A- 9 013 278** | **JP-A- 9 134 614** |
| **JP-A- 10 152 561** | **JP-A- 58 210 976** |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### FIELD OF THE INVENTION

The present invention relates to a light-emitting diode device comprising an optical semiconductor element encapsulated with a resin for optical semiconductor element encapsulation.

### BACKGROUND OF THE INVENTION

Recently, a demand for a light-emitting diode (LED) has been increased as a low-power-consumption, long-life, small-size, and lightweight light source and, for example, LED has been widely used in a backlight for a liquid crystal screen, a traffic signal, an outdoor large display, an advertising signboard, and the like. Moreover, in addition to LED of red, green, and blue colors which are three primary colors, white LED has been currently developed and is strongly expected as a next-generation lighting source instead of a light bulb or a fluorescent lamp from the viewpoints of energy saving and low environmental burden.

As one of important peripheral materials supporting the performance of LED, an encapsulating material plays a role of sealing and protecting LED so that the performance of LED does not deteriorate. Conventionally, epoxy resins have been widely used as an encapsulating material and JP-A-2006-274249 reports that an epoxy resin composition containing a specific component is excellent in resistance against photodeterioration.

Other than epoxy resins, there is disclosed a technology that a silicone resin excellent in light resistance and heat resistance is utilized for encapsulation of high-output or blue and white LED (see JP-A-2006-202952, corresponding to EP-A-1684363).

On the other hand, as a silicone resin, there has been known a polyborosiloxane resin having a chemical structure where a part of silicon atoms in the silicone are replaced by boron atoms. Since the polyborosiloxane resin is excellent in heat resistance, it is used as an insulating coating film for electric wires which require heat resistance. JP-A-10-152561 reports that a polyborosiloxane having both of heat resistance and humidity resistance is obtained by a two-stage reaction of specific silicon compounds.

However, since an epoxy resin as an encapsulating material is not sufficient in heat resistance, there arises a problem of deterioration of the resin with the increasing use of larger electric current due to the increase in light-emitting efficiency and luminous flux of LED. Specifically, in the case where an epoxy resin is utilized for encapsulation of high-output LED, the epoxy resin is changed into yellow due to heat generated in the LED chip, so that there arises a problem of decrease in emission luminance. Further, in the case where blue or white LED is encapsulated, there arises a problem that exposure to short-wavelength light (e.g., light having a wavelength of 350 to 500 nm) having a large energy causes photodegradation and thus yellowing occurs more severely. Moreover, a silicone resin is excellent in heat resistance but the synthesis is cumbersome and complicated and the raw materials themselves cost high, so that there arises a problem that a product cannot be supplied at a low cost.

JP-A-08-268735 discloses a heat-resistant laminated glass comprising an intermediate adhesive layer of a polymetallosiloxane such as polyborosiloxane. The polymetallosiloxane is produced by mixing a silicone oil with a silane compound and a boric acid compound and heating the mixture in order to effect a condensation polymerization.

JP-A-58-210976 discloses a resin composition for use in bonding metallic members, said composition being prepared by mixing a polyborosiloxane resin with a silicone resin and an inorganic filler in specific amounts.

JP-A-09-134614 discloses a heat-resistant insulated wire comprising a conductor coated with a coating layer, said layer being made from a polyborosiloxane resin.

JP-A-09-013278 discloses the use of a coating material comprising a polyborosiloxane resin for the preparation of heat-resistant fibers and heat-resistant insulated wires.

### SUMMARY OF THE INVENTION

The object of the present invention is to provide a light-emitting diode device comprising an optical semiconductor element encapsulated with a resin for optical semiconductor element encapsulation, said resin containing a polyborosiloxane excellent in all of heat resistance, transparency, and light resistance.

This object is solved by a light-emitting diode device comprising an optical semiconductor element encapsulated with a resin for optical semiconductor element encapsulation, wherein the resin comprises a polyborosiloxane obtained by reacting a silicon compound with a boron compound,
wherein the silicon compound is at least one of
a bifunctional silicon compound represented by the following formula (I):

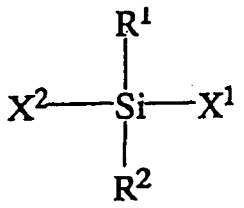

(I)

wherein $R^1$ and $R^2$ each independently represent an alkyl group, a cycloalkyl group, an alkenyl group, an alkynyl group or an aryl group, and $X^1$ and $X^2$ each independently represent an alkoxy group, a hydroxyl group or a halogen atom; and

a trifunctional silicon compound represented by the following formula (II):

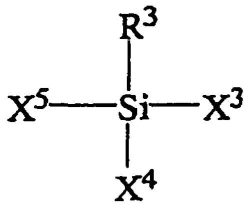

(II)

wherein $R^3$ represents an alkyl group, a cycloalkyl group, an alkenyl group, an alkynyl group or an aryl group, and $X^3$, $X^4$ and $X^5$ each independently represent an alkoxy group, a hydroxyl group or a halogen atom, and

wherein the boron compound is a boric acid compound or a boric acid ester compound represented by the following formula (III):

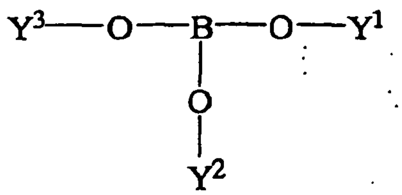

(III)

wherein $Y^1$, $Y^2$ and $Y^3$ each independently represent a hydrogen atom or an alkyl group.

The resin for optical semiconductor element encapsulation used in the invention exhibits an excellent advantage that it is excellent in all of heat resistance, transparency, and light resistance. Therefore, the optical semiconductor device encapsulated using the resin can achieve a longer operating life.

The resin containing a polyborosiloxane used in the invention is suitably used as a material for encapsulating an optical semiconductor element in a backlight for a liquid crystal screen, a traffic signal, an outdoor large display, an advertising signboard, and the like.

**BRIEF DESCRIPTION OF THE DRAWINGS**

FIG. 1 is a cross-sectional view of a substrate of an LED device before encapsulation processing.

FIG. 2 is a cross-sectional view of a substrate of an LED device after encapsulation processing.

Description of the Reference Numerals and Signs

1 optical semiconductor element

2 substrate

3 reflector

4 resin for optical semiconductor element encapsulation

## DETAILED DESCRIPTION OF THE INVENTION

The resin for optical semiconductor element encapsulation contains a polyborosiloxane obtained by reacting a silicon compound with a boron compound.

As the silicon compound, at least one of specific bifunctional or trifunctional silicon compounds is used.

The bifunctional silicon compound is a compound represented by the following formula (I):

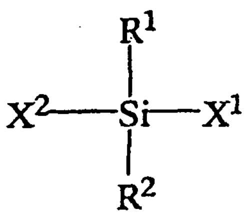

(I)

wherein $R^1$ and $R^2$ each independently represent an alkyl group, a cycloalkyl group, an alkenyl group, an alkynyl group, or an aryl group, and $X^1$ and $X^2$ each independently represent an alkoxy group, a hydroxyl group, or a halogen atom,

$R^1$ and $R^2$ in the formula (I) each independently represent an alkyl group, a cycloalkyl group, an alkenyl group, an alkynyl group, or an aryl group, and the carbon number of each of the functional groups is preferably 1 to 18, more preferably 1 to 12, and further preferably 1 to 6. Specifically, examples thereof include alkyl groups such as a methyl group, an ethyl group, a propyl group, and an isopropyl group; a cycloalkyl groups such as a cyclopentyl group, a cyclohexyl group, and a norbornyl group; alkenyl groups such as a vinyl group and an allyl group; alkynyl groups such as an ethynyl group and a propynyl group; and aryl groups such as a phenyl group, a tolyl group, and a naphthyl group. Of these, alkyl groups and aryl groups are preferred, and it is preferable that $R^1$ and $R^2$ each independently are a methyl group or a phenyl group.

$X^1$ and $X^2$ in the formula (I) each independently represent an alkoxy group, a hydroxyl group, or a halogen atom, and the carbon number of the alkoxy group is preferably 1 to 4 and more preferably 1 to 2. Specifically, examples thereof include a methoxy group and an ethoxy group. Moreover, as the halogen atom, chlorine atom and bromine atom are preferred and chlorine atom is more preferred.

As the bifunctional silicon compound represented by the formula (I), there may be mentioned diphenyldimethoxysilane, dimethyldimethoxysilane, diphenyldihydroxysilane, dimethyldiethoxysilane, diphenyldiethoxysilane, diethyldimethoxysilane, diethyldiethoxysilane, diisopropyldimethoxysilane, diisopropyldiethoxysilane, methylphenyldimethoxysilane, methylphenyldiethoxysilane, dimethyldichlorosilane, diphenyldichlorosilane, diethyldichlorosilane, diisopropyldichlorosilane or, methylphenyldichlorosilane, and they may be used singly or as a combination of two or more thereof. Of these, preferred are dimethyldimethoxysilane in which $R^1$ and $R^2$ each are a methyl group and $X^1$ and $X^2$ each are a methoxy group, and diphenyldimethoxysilane in which $R^1$ and $R^2$ each are a phenyl group and $X^1$ and $X^2$ each are a methoxy group.

The trifunctional silicon compound is a compound represented by the following formula (II):

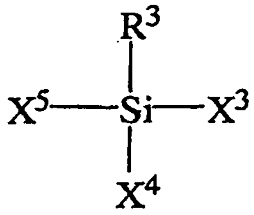

(II)

wherein $R^3$ represents an alkyl group, a cycloalkyl group, an alkenyl group, an alkynyl group, or an aryl group and $X^3$, $X^4$ and $X^5$ each independently represent an alkoxy group, a hydroxyl group, or a halogen atom.
$R^3$ in the formula (II) represents an alkyl group, a cycloalkyl group, an alkenyl group, an alkynyl group, or an aryl group, and the carbon number of each of the functional groups is preferably 1 to 18, more preferably 1 to 12, and further preferably 1 to 6. As such functional groups, there may be mentioned functional groups the same as those mentioned as the aforementioned specific examples of $R^1$ and $R^2$ in the formula (I). Of these, $R^3$ is preferably an alkyl group or an aryl group and more preferably a methyl group or a phenyl group.
$X^3$, $X^4$, and $X^5$ in the formula (II) each independently represent an alkoxy group, a hydroxyl group, or a halogen atom and the carbon number of the alkoxy group is preferably 1 to 4 and more preferably 1 to 2. Specifically, there may be mentioned alkoxy groups the same as the alkoxy groups mentioned for $X^1$ and $X^2$ in the formula (1). Moreover, as the halogen atom, chlorine atom and bromine atom are preferred and chlorine atom is more preferred.

As the trifunctional silicon compound represented by the formula (II), there may be mentioned phenyltrimethoxysilane, methyltrimethoxysilane, methyltrichlorosilane, phenyltrichlorosilane, phenyltriethoxysilane, methyltriethoxysilane, ethyltrimethoxysilane, ethyltrichlorosilane, isopropyltrimethoxysilane, or isopropyltrichlorosilane, and they may be used singly or as a combination of two or more thereof. Of these, preferred are methyltrimethoxysilane in which $R^3$ is a methyl group and $X^3$, $X^4$, and $X^5$ each are a methoxy group, and phenyltrimethoxysilane in which $R^3$ is a phenyl group and $X^3$, $X^4$, and $X^5$ each are a methoxy group.

Moreover, the resin for encapsulation may contain a silicon compound other than the bifunctional silicon compound represented by the formula (I) and the trifunctional silicon compound represented by the formula (II) within a range where the advantage of the invention is not impaired. For obtaining heat resistance, transparency, and light resistance which are purposes of the invention, the total content of the bifunctional silicon compound represented by the formula (I) and the trifunctional silicon compound represented by the formula (II) in the silicon compounds subjected to the reaction is preferably 30% by weight or more, more preferably 50% by weight or more, and further preferably 60 to 100% by weight or more.

In the case of using the bifunctional silicon compound represented by the formula (I) and the trifunctional silicon compound represented by the formula (II) in combination, the weight ratio (bifunctional silicon compound /trifunctional silicon compound) of the bifunctional silicon compound represented by the formula (I) to the trifunctional silicon compound represented by the formula (II) is preferably 20/1 to 1/10, and more preferably 5/1 to 1/2.

Furthermore, with regard to the polyborosiloxane, since light resistance and transparency vary depending on the functional groups of the raw materials used, the functional groups of $R^1$ and $R^2$ in the formula (I) and $R^3$ in the formula (II) preferably satisfies such a relationship that the molar ratio (alkyl group/aryl group) of the alkyl group to the aryl group is 100/0 to 5/95, and more preferably 100/0 to 15/85.

The boron compound is a boric acid compound or a boric acid ester compound represented by the following formula (III):

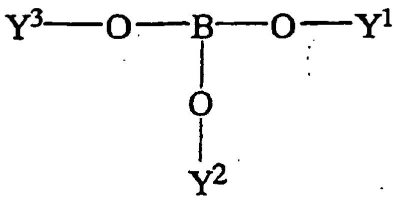

(III)

wherein $Y^1$, $Y^2$, and $Y^3$ each independently represent a hydrogen atom or an alkyl group.

The carbon number of the alkyl group in the formula (III) is preferably 1 to 12, more preferably 1 to 6, and further preferably 1 to 3. Specific examples thereof include a methyl group, an ethyl group, a propyl group, and an isopropyl group. Of these, preferred are an ethyl group and an isopropyl group, and more preferred is an ethyl group.

As the compound represented by the formula (III), there may be mentioned boric acid, methyl borate, ethyl

borate, or isopropyl borate, and they may be used singly or as a combination of two or more thereof. Of these, preferred are boric acid, ethyl borate, and isopropyl borate, and more preferred are boric acid and ethyl borate.

The polycondensation of the silicon compound with the boron compound can be carried out, for example, at a temperature of 60 to 200°C under an inert gas atmosphere and in the absence of a solvent. In the case where a plurality of the silicon compounds are used, although the compounds may be subjected to the reaction at a time, since the reactivity varies depending on the functional groups of the compounds, each of the compounds can be separately subjected to the reaction.

The total weight ratio (silicon compound/boron compound) of the silicon compound to the boron compound is preferably 500/1 to 1/1, more preferably 100/1 to 2/1, further preferably 20/1 to 2/1, and still further preferably 5/1 to 2/1.

After the polycondensation of the silicone compound with the boron compound, by-products may be removed by evaporation, for example, by heat treatment at 100 to 200°C for 1 to 12 hours and then at 200 to 300°C for 1 to 24 hours.

With regard to the resultant reaction product, peaks characteristic to siloxane and borosiloxane are confirmed at 1127±10, 1075±10, 868±30, 718±5, 697±5 $cm^{-1}$ in accordance with the measurement of infrared absorption spectra.

The softening point of the resin used in the invention is preferably 50 to 300°C, more preferably 80 to 250°C from the viewpoint of moldability and processability. In the present specification, the softening point is measured in acccordance with the method described in the following Examples.

Moreover, the transparency (transmittance at 450 nm) of the resin used in the invention is preferably 90% or more and more preferably 95% or more from the viewpoint of improving light resistance. In the present specification, the transparency (transmittance at 450 nm) is measured in accordance with the method described in the following Examples.

Since the thus obtained resin containing the polyborosiloxane is not only excellent in heat resistance but also excellent in transparency and light resistance, it can be suitably used as a resin for optical semiconductor element encapsulation in a backlight for a liquid crystal screen, a traffic signal, an outdoor large display, an advertising signboard, and the like.

Since the optical semiconductor device of the invention includes the resin containing the polyborosiloxane excellent in heat resistance, transparency, and light resistance as a resin for optical semiconductor element encapsulation, it becomes possible to maintain the emission luminance in a high state for a long period of time without deterioration of the encapsulating resin and thus the device can be suitably used.

## Examples

### Infrared Absorption Spectrum of Resin

The resin was measured in accordance with the direct ATR method using an FTIR apparatus (FTIR-470, manufactured by JASCO Corporation).

### Softening Point of Resin

The resin was slowly heated to 250°C on a hot plate, the state was visually observed, and a temperature where the resin was softened so as to show slight flowability was determined as a softening point.

### Transparency of Resin (Transmittance at 450 nm)

The resin was dissolved in methyl ethyl ketone and the solution was applied on a glass plate and dried at 150°C for 1 hour to form a film (film thickness: 50 μm). The resultant sample was subjected to the measurement of transmittance using a spectrophotometer (U-4100, manufactured by Hitachi High-Technologies Corporation).

### Example 1 (Polyborosiloxane A)

Under a nitrogen atmosphere, 12.73 g of diphenyldimethoxysilane and 1.07 g of boric acid were stirred and reacted at 80°C for 12 hours. After the resultant colorless transparent liquid was once cooled to room temperature, 3.45 g of phenyltrimethoxysilane and 1.07 g of boric acid were added thereto, the temperature was again elevated to 80°C, and the whole was stirred and reacted for 3 hours. Thereafter, the formed colorless transparent liquid was subjected to heat treatment at 150°C for 1 hour and further at 200°C for 3 hours in a hot-air dryer and by-products were removed by evaporation to obtain 11.3 g of a polyborosiloxane A. In the measurement of infrared absorption spectrum of the polyborosiloxane A, peaks were observed at 1127, 1075, 868, 718, and 697 $cm^{-1}$.

Example 2 (Polyborosiloxane B)

Under a nitrogen atmosphere, 8.00 g of diphenyldimethoxysilane and 0.68 g of boric acid were stirred and reacted at 80°C for 24 hours. After the resultant colorless transparent liquid was once cooled to room temperature, 1.48 g of methyltrimethoxysilane and 0.68 g of boric acid were added thereto, the temperature was again elevated to 80°C, and the whole was stirred and reacted for 24 hours. Thereafter, the formed colorless transparent liquid was subjected to heat treatment at 150°C for 1 hour and further at 200°C for 3 hours in a hot-air dryer and by-products were removed by evaporation to obtain 6.5 g of a polyborosiloxane B. In the measurement of infrared absorption spectrum of the polyborosiloxane B, peaks were observed at 1131, 1081, 879, 719, and 697 $cm^{-1}$.

Example 3 (Polyborosiloxane C)

Under a nitrogen atmosphere, 6.25 g of dimethyldimethoxysilane and 1.07 g of boric acid were stirred and reacted at 80°C for 6 hours. After the resultant colorless transparent liquid was once cooled to room temperature, 3.45 g of phenyltrimethoxysilane and 1.07 g of boric acid were added thereto, the temperature was again elevated to 80°C, and the whole was stirred and reacted for 24 hours. Thereafter, the formed colorless transparent liquid was subjected to heat treatment at 150°C for 1 hour and further at 200°C for 3 hours in a hot-air dryer and by-products were removed by evaporation to obtain 4.1 g of a polyborosiloxane C. In the measurement of infrared absorption spectrum of the polyborosiloxane C, peaks were observed at 1133, 1083, 888, 717, and 698 $cm^{-1}$.

Example 4 (Polyborosiloxane D)

Under a nitrogen atmosphere, 6.03 g of dimethyldimethoxysilane and 1.04 g of boric acid were stirred and reacted at 80°C for 6 hours. After the resultant colorless transparent liquid was once cooled to room temperature, 2.28 g of methyltrimethoxysilane and 1.04 g of boric acid were added thereto, the temperature was again elevated to 80°C, and the whole was stirred and reacted for 24 hours. Thereafter, the formed colorless transparent liquid was subjected to heat treatment at 150°C for 1 hour and further at 200°C for 3 hours in a hot-air dryer and by-products were removed by evaporation to obtain 2.2 g of a polyborosiloxane D. In the measurement of infrared absorption spectrum of the polyborosiloxane D, peaks were observed at 1125, 1069, 844, 717, and 697 $cm^{-1}$.

Example 5 (Polyborosiloxane E)

Under a nitrogen atmosphere, 7.02 g of dimethyldimethoxysilane and 1.80 g of boric acid were stirred and reacted at 80°C for 18 hours. The resultant colorless transparent liquid was subjected to heat treatment at 150°C for 1 hour and further at 200°C for 3 hours in a hot-air dryer and by-products were removed by evaporation to obtain 1.2 g of a polyborosiloxane E. In the measurement of infrared absorption spectrum of the polyborosiloxane E, peaks were observed at 1130, 1075, 855, 717, and 698 $cm^{-1}$.

Comparative Example 1 (Epoxy Resin A)

Into a methyl ethyl ketone solvent were dissolved 45 parts by weight of an epoxy resin having an epoxy equivalent of 7500 and having a bisphenol A skeleton (BFA) (EP1256, manufactured by Japan Epoxy Resins Co., Ltd.), 33 parts by weight of an epoxy resin having an epoxy equivalent of 260 and having an alicyclic skeleton (EHPE3150, manufactured by Daicel Chemical Industries, Ltd.), 22 parts by weight of 4-methylhexahydrophthalic anhydride (MH-700, manufactured by New Japan Chemical Co., Ltd.), and 1.2 parts by weight of 2-methylimidazole (2MZ, manufactured by Shikoku Chemicals Corporation) so as to achieve a concentration of 50% by weight, to thereby obtain a solution for coating. The solution was applied on a biaxially oriented polyester film (50 μm, manufactured by Mitsubishi Chemical Polyester) so as to achieve a thickness of 100 μm, and the whole was dried at 130°C for 2 minutes to obtain a sheet containing an epoxy resin. Thereafter, three pieces of sheets obtained in the same manner were thermally laminated at 100°C to obtain an epoxy sheet (epoxy resin A) having a thickness of 300 μm.

Properties of the resultant resins were investigated according to the method of the following Test Example 1. Table 1 shows the results.

Test Example 1 (Heat Resistance)

The resin of each of Examples and Comparative Example was allowed to stand in a hot-air dryer at 250°C for 100 hours. The transparency of the resin after the passage of 100 hours was visually observed and the resin where no change was observed from the state before storage was evaluated as "Good" and the resin where change was observed

from the state before storage as "poor".

Then, encapsulation processing was performed using the resultant resin to produce an LED device. In this connection, FIG. 1 shows a substrate of the LED device before encapsulation processing and FIG. 2 shows a substrate of the LED device after encapsulation processing.

Examples 6 to 10 (LED Devices)

Each of LED devices of Examples 6 to 10 was produced by LED encapsulation in which a substrate mounted with a blue LED element having a size of 1 mm square and a reflector having a height of 400 μm sited around the LED element and 5 mm distant therefrom was heated to the encapsulating temperature shown in Table 1 and then 120 mg of the resin shown in Table 1 was put on the LED element and melted.

Comparative Example 2 (LED Device)

An LED device of Comparative Example 1 was produced by LED encapsulation in which a substrate mounted with a blue LED element having a size of 1 mm square and a reflector having a height of 400 μm sited around the LED element and 5 mm distant therefrom was heated to the encapsulating temperature shown in Table 1 and then the resin shown in Table 1 was put on the LED element and subjected to encapsulation processing with a pressure of 0.5 MPa.

Properties of the resultant LED devices were investigated according to the method of the following Test Example 2. Table 1 shows the results.

Test Example 2 (Light Resistance)

An electric current of 300 mA was passed through the LED device of each of Examples and Comparative Example and luminance immediately after the start of the test was measured by an instantaneous multi photometric system (MCPD-3000, manufactured by Otsuka Electronics Co., Ltd.). Thereafter, the device was allowed to stand in the current-flowing state and luminance after the passage of 300 hours was measured in a similar manner. Luminance retention was calculated according to the following equation to evaluate light resistance. In this connection, those having a luminance retention of 70% or more were judged to be good.

$$\text{Luminance Retention (\%)} = (\text{Luminance after passage of 300 hours}/\text{Luminance immediately after start of test}) \times 100$$

Table 1

| | | Example 6 | Example 7 | Example 8 | Example 9 | Example 10 | Comparative Example 2 |
|---|---|---|---|---|---|---|---|
| Resin | | Polyborosiloxane A (Example 1) | Polyborosiloxane B (Example 2) | Polyborosiloxane C (Example 3) | Polyborosiloxane D (Example 4) | Polyborosiloxane E (Example 5) | Epoxy resin A (Comparative Example 1) |
| Alkyl group/aryl group[1)] | | 0/100 | 14/86 | 86/14 | 100/0 | 100/0 | - |
| Resin | Softening point (°C) | 80 | 100 | 200 | 250 | 250 | impossible to measure[2)] |
| | Transparency (%) | 97 | 98 | 100 | 100 | 100 | 95 |
| | Heat resistance | good | good | good | good | good | poor |
| Encapsulation processing temperature | | 100 | 100 | 250 | 250 | 250 | 150 |
| Device | Luminance retention (%) | 97 | 98 | 98 | 99 | 100 | 40 |

1) It shows a molar ratio (alkyl group/aryl group) of the alkyl group to the aryl group among the functional groups in the silicon compound(s) as raw material(s).
2) It is impossible to measure since the resin is not softened even at 250°C.

From the above results, it is shown that the LED devices of Examples have high luminance retention as compared with the LED device of Comparative Example and thus excellent in light resistance. In particular, since the LED devices of Examples 8 to 10 (resins of Examples 3 to 5) have a molar ratio (alkyl group/aryl group) of the alkyl group to the aryl group of 86/14 or 100/0 with regard to the functional groups of the silicone compounds which are raw materials of the encapsulating resins, transparency and light resistance are more excellent.

## Claims

1. A light-emitting diode device comprising an optical semiconductor element encapsulated with a resin for optical semiconductor element encapsulation, wherein the resin comprises a polyborosiloxane obtained by reacting a silicon compound with a boron compound,
wherein the silicon compound is at least one of
a bifunctional silicon compound represented by the following formula (I):

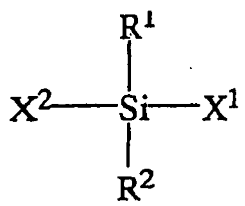

(I)

wherein $R^1$ and $R^2$ each independently represent an alkyl group, a cycloalkyl group, an alkenyl group, an alkynyl group or an aryl group, and $X^1$ and $X^2$ each independently represent an alkoxy group, a hydroxyl group or a halogen atom; and

a trifunctional silicon compound represented by the following formula (II):

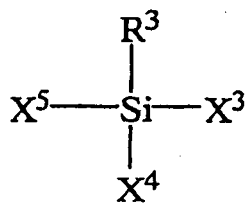

(II)

wherein $R^3$ represents an alkyl group, a cycloalkyl group, an alkenyl group, an alkynyl group or an aryl group, and $X^3$, $X^4$ and $X^5$ each independently represent an alkoxy group, a hydroxyl group or a halogen atom, and

wherein the boron compound is a boric acid compound or a boric acid ester compound represented by the following formula (III):

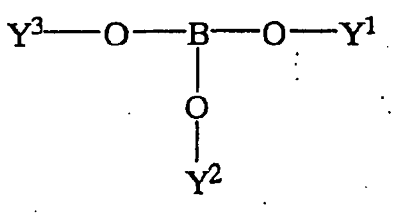

(III)

wherein $Y^1$, $Y^2$ and $Y^3$ each independently represent a hydrogen atom or an alkyl group.

## Patentansprüche

1. Lichtemittierende Diodenvorrichtung, umfassend ein optisches Halbleiterelement, das mit einem Harz zum Einbetten von optischen Halbleiterelementen eingebettet ist, wobei das Harz ein Polyborosiloxan umfasst, das durch Umsetzen einer Siliciumverbindung mit einer Borverbindung erhalten wird,
wobei die Siliciumverbindung wenigstens eine von
einer bifunktionellen Siliciumverbindung, die durch die folgende Formel (I) wiedergegeben ist:

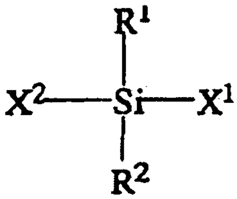

(I)

worin $R^1$ und $R^2$ jeweils unabhängig voneinander eine Alkylgruppe, eine Cycloalkylgruppe, eine Alkenylgruppe, eine Alkinylgruppe oder eine Arylgruppe bedeuten und $X^1$ und $X^2$ jeweils unabhängig voneinander eine Alkoxygruppe, eine Hydroxylgruppe oder ein Halogenatom bedeuten; und

einer trifunktionellen Siliciumverbindung ist, die durch die folgende Formel (II) wiedergegeben ist:

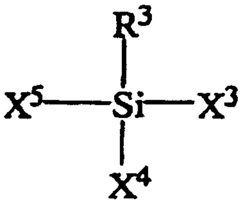

(II)

worin $R^3$ eine Alkylgruppe, eine Cycloalkylgruppe, eine Alkenylgruppe, eine Alkinylgruppe oder eine Arylgruppe bedeutet und $X^3$, $X^4$ und $X^5$ jeweils unabhängig voneinander eine Alkoxygruppe, eine Hydroxylgruppe oder ein Halogenatom bedeuten, und

wobei die Borverbindung eine Borsäureverbindung oder eine Borsäureesterverbindung ist, die durch die folgende Formel (III) wiedergegeben ist:

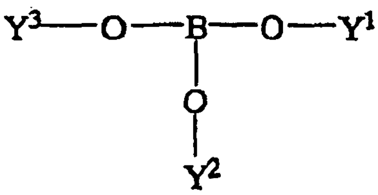

(III)

worin $Y^1$, $Y^2$ und $Y^3$ jeweils unabhängig voneinander ein Wasserstoffatom oder eine Alkylgruppe bedeuten.

## Revendications

1. Dispositif de diode électroluminescente comprenant un élément optique semi-conducteur encapsulé dans une résine d'encapsulation d'élément optique semi-conducteur, où ladite résine comprend un polyborosiloxane obtenu par réaction d'un composé du silicium avec un composé du bore,
le composé du silicium étant au moins l'un
d'un composé bifonctionnel du silicium représenté par la formule (I) ci-après :

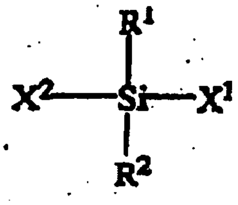

(I)

où $R^1$ et $R^2$ représentent chacun, indépendamment l'un de l'autre, un groupe alkyle, un groupe cycloalkyle, un groupe alcényle, un groupe alcynyle ou un groupe aryle, et $X^1$ et $X^2$ représentent chacun, indépendamment l'un de l'autre, un groupe alcoxy, un groupe hydroxyle ou un atome d'halogène ; et

d'un composé trifonctionnel du silicium représenté par la formule (II) ci-après :

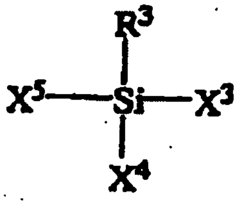

(II)

où $R^3$ représente un groupe alkyle, un groupe cycloalkyle, un groupe alcényle, un groupe alcynyle ou un groupe aryle, et $X^3$, $X^4$ et $X^5$ représentent chacun, indépendamment les uns des autres, un groupe alcoxy, un groupe hydroxyle ou un atome d'halogène, et

le composé du bore étant un composé acide borique ou un composé ester d'acide borique représenté par la formule (III) ci-après :

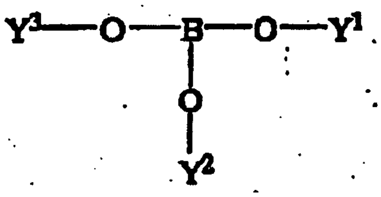

(III)

où $Y^1$, $Y^2$ et $Y^3$ représentent chacun, indépendamment les uns des autres, un atome d'hydrogène ou un groupe alkyle.

*Fig. 1*

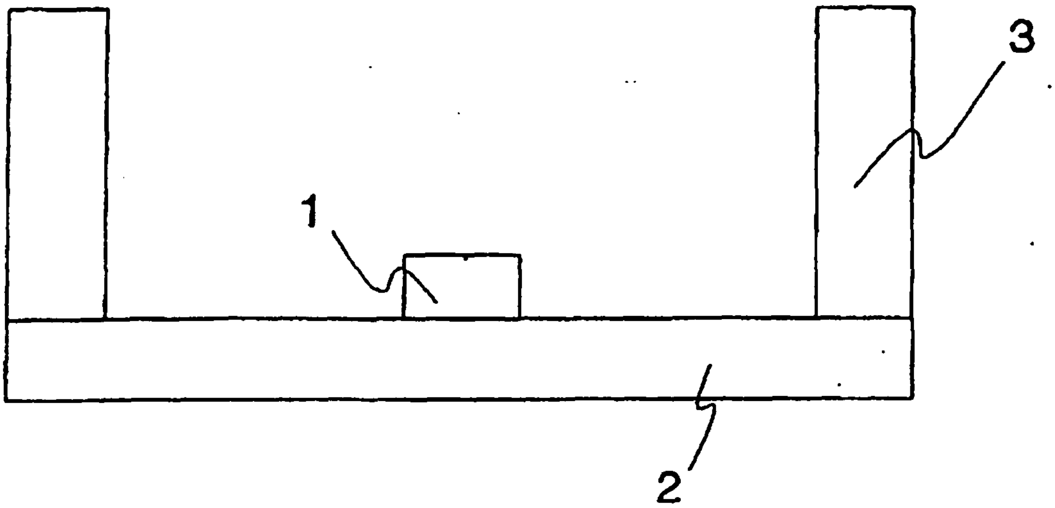


*Fig. 2*

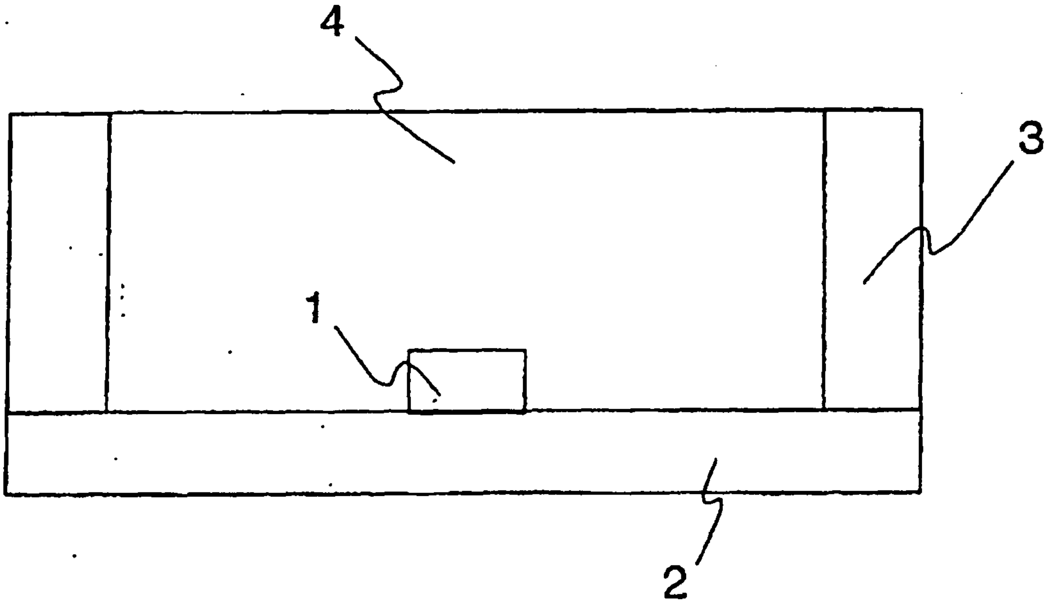

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006274249 A
- JP 2006202952 A
- EP 1684363 A
- JP 10152561 A
- JP 8268735 A
- JP 58210976 A
- JP 9134614 A
- JP 9013278 A
- EP 1256 A